# EUROPÄISCHE PATENTSCHRIFT

(11) **EP 3 665 491 B1**
(45) Veröffentlichungstag und Bekanntmachung des Hinweises auf die Patenterteilung: **28.10.2026**
(21) Anmeldenummer: 18750095.4
(22) Anmeldetag: 13.07.2018
(51) Int. Cl.: G01R 31/28, G01R 31/311, G02B 6/43, H04B 10/80, G02B 6/42

(54) **LAGETOLERANZUNEMPFINDLICHES KONTAKTIERUNGSMODUL ZUR KONTAKTIERUNG OPTOELEKTRONISCHER CHIPS**
POSITION-TOLERANCE-INSENSITIVE CONTACTING MODULE FOR CONTACTING OPTOELECTRONIC CHIPS
MODULE DE CONTACT INSENSIBLE À LA TOLÉRANCE DE POSITION DESTINÉ AU CONTACT DE PUCES OPTOÉLECTRONIQUES

(30) Priorität: 07.08.2017 DE 102017117839; 11.09.2017 DE 102017008618; 24.10.2017 DE 102017010066; 08.03.2018 DE 102018002032
(43) Veröffentlichungstag der Anmeldung: 17.06.2020
(73) Patentinhaber: JENOPTIK Optical Systems GmbH, 07745 Jena (DE)
(72) Erfinder: GNAUSCH, Tobias, 07743 Jena (DE); BÜTTNER, Robert, 07749 Jena (DE); KADEN, Thomas, 01097 Dresden (DE); JUHASZ, Thomas, 99428 Weimar (DE); GRUNDMANN, Armin, 07743 Jena (DE); VON FREYHOLD, Thilo, 99423 Weimar (DE)
(74) Vertreter: Gleim Petri Patent- und Rechtsanwaltspartnerschaft mbB
(86) Internationale Anmeldenummer: PCT/DE2018/100642
(87) Internationale Veröffentlichungsnummer: WO 2019/029765

(56) Entgegenhaltungen:
- EP-A1- 2 748 956
- US-A1- 2004 022 488
- US-A1- 2004 101 238
- US-A1- 2008 310 852
- US-A1- 2011 279 812

## Beschreibung

Die Erfindung ist im Bereich des Testens und Qualifizierens von optisch-elektrisch integrierten Schaltungen, sogenannten PICs (Photonic Integrated Circuits), auf Wafer-Ebene angesiedelt. Im Unterschied zu herkömmlichen, rein elektrisch integrierten Schaltungen, sogenannten ICs (Integrated Circuits), sind bei PICs neben den elektrischen Schaltungen auch optische Funktionalitäten integriert.

Bei der Herstellung von ICs, z. B. mittels CMOS-Technologie, finden in verschiedenen Herstellungsschritten Tests und Messungen statt, um einerseits den Prozess zu überwachen und andererseits eine Qualitätskontrolle durchzuführen. Ein etablierter Test ist dabei der elektrische Wafer Level Test nach der Fertigstellung des Wafers. Hier werden funktionale und nicht-funktionale Chips ermittelt, in einer Wafermap erfasst und damit die Ausbeute bestimmt. Funktionale Chips werden auch als Known Good Dies (KGD) bezeichnet. Beim Vereinzeln des Wafers in einzelne Chips erfolgt dann das Aussortieren der nicht funktionalen Chips. Die für den Wafer Level Test benötigte Testapparatur steht in Form von Waferprobern und Wafertestern mit zugehörigen Kontaktierungsmodulen (auch Probecards genannt) zur Verfügung. Mittels des Kontaktierungsmoduls werden die geräteseitigen Schnittstellen (Ein- und Ausgänge) des Wafertesters mit den individuellen Schnittstellen (Ein- und Ausgänge) der Chips des auf dem Waferprober fixierten Wafers verbunden. Grundsätzlich kann das Kontaktierungsmodul so ausgeführt sein, dass es nur einen oder aber auch zeitgleich mehrere Chips kontaktiert. Es ist auch nicht zwingend erforderlich, dass die Chips zur Kontaktierung noch im Waferverbund vorliegen. Um gleichzeitig mehrere oder auch nacheinander die Chips eines Wafers zu kontaktieren, müssen die Chips lediglich eine fixierte und definierte Lage zueinander aufweisen. Dieser Spielraum ist für Kontaktierungsmodule des Standes der Technik ebenso gegeben wie für ein erfindungsgemäßes Kontaktierungsmodul.

Testapparaturen zum Testen rein elektronischer Chips (Halbleiterchip mit ICs) wurden über Jahrzehnte optimiert und diversifiziert, um zur Kostenoptimierung hohe Volumina unterschiedlichster ICs mit hohem Durchsatz qualifizieren zu können.

Die Herstellung der PICs erfolgt i.d.R. mit den gleichen etablierten Halbleiterprozessen, z. B. der CMOS-Technologie. Die bisher im Vergleich zur IC-Herstellung sehr geringen Fertigungsvolumina von PICs führten dazu, dass i.d.R. in einer Halbleiterfabrik nur Tests zur Prozesscharakterisierung, aber keine funktionalen Tests der PICs durchgeführt wurden. Die funktionale Charakterisierung obliegt dem Endkunden und wird oft an gesägten Chips durchgeführt. Die benutzte Testapparatur verwendet voneinander unabhängige, getrennte elektrische und optische Kontaktierungsmodule und ist nicht auf Durchsatz optimiert, insbesondere erlaubt sie nicht das parallele Messen mehrerer PICs.

Das Testen von PICs auf Wafer-Level-Ebene erfordert das Ein- und Auskoppeln von Licht aus der Ebene der PICs heraus, i.d.R. mittels integrierter Grating-Koppler als Koppelstellen, wie in der Fachliteratur "Grating Couplers for Coupling between Optical Fibers and Nanophotonic Waveguides" (D. Taillaert et al, Japanese Journal of Applied Physics, Vol. 45, No. 8A, 2006, S. 6071-6077) beschrieben. Die Grating Couplers können funktionaler Bestandteil im Chip oder Opferstrukturen auf dem Wafer z. B. im Ritzgraben oder auf benachbarten Chips sein.

Dem Stand der Technik entsprechend werden glasfaserbasierte Systeme für den Wafer Level Test verwendet, wie in der Fachliteratur: "Test-station for flexible semi-automatic wafer-level silicon photonics testing" beschrieben (J. De Coster et al, 21th IEEE European Test Symposium, ETS 2016, Amsterdam, Netherlands, May 23-27, 2016. IEEE 2016, ISBN 978-1-4673-9659-2). Diese beinhalten ein glasfaserbasiertes Optikmodul, das über einzelne Glasfasern Licht in die Koppelstellen des Chips ein- und auskoppelt. Um eine wiederholgenaue optische Kopplung zu gewährleisten, müssen die Glasfasern zum einen submikrometergenau zu den Koppelstellen in einem Abstand bis zu wenigen Mikrometern justiert werden. Dies ist nur unter Zuhilfenahme hochpräziser Stellelemente in Kombination von Hexapoden mit Piezoelementen möglich. Zum anderen muss vor jeder einzelnen optischen Kopplung ein zeitintensiver, aktiver und auf das Erreichen maximaler Koppeleffizienz ausgelegter Justageablauf erfolgen.

Damit sind bestehende Wafer-Level-Test-Systeme gekennzeichnet durch
- sequentielles, zeitintensives Kontaktieren aller optischen Koppelstellen eines Chips nacheinander, d. h. eine parallele Kontaktierung aller optischen Koppelstellen eines Chips ist nicht oder nur stark eingeschränkt möglich, eine parallele Kontaktierung mehrerer Chips gar nicht möglich.
- geräteseitige Sonderlösungen, so dass herkömmliche Waferprober nur mit aufwendigen und kostenintensiven Modifikationen umrüstbar und danach nicht mehr oder nur bedingt für den Wafer Level Test von ICs einsetzbar sind.
- getrennte, nicht fest miteinander verbundene Elektronik- und Optikmodule, d. h. beide müssen separat gehaltert und justiert werden.

Aus der vorgenannten US 2006/0109015 A1 ist ein optoelektronisches Kontaktierungsmodul (probe module) zum Testen von Chips mit elektrischen und optischen Ein- und Ausgängen (zu untersuchendes Objekt - DUT 140) bekannt, enthaltend eine Kontaktierungsplatte (probe substrate) und eine Umverteilungsplatte (redistribution substrate). Das Kontaktierungsmodul stellt eine Schnittstelle zwischen einer Testapparatur (ATE) und dem DUT dar und ist mit elektrischen Kontakten (electical probes), optischen Kontakten (optical probes), optischen Elementen und Kombinationen hiervon ausgeführt, um Signale von dem DUT und zu dem DUT zu leiten und diese Signale umzuverteilen für eine Schnittstelle zur Testapparatur.

Die Auftrennung in eine Kontaktierungsplatte und eine Umverteilungsplatte führt zu einem modularen Design des Kontaktierungsmoduls, woraus sich der Vorteil ergibt, dass im Falle der Beschädigung der Kontakte die Kontaktierungsplatte ersetzt werden kann, während die Umverteilungsplatte mit dem vergleichsweise teuren elektrischen und optischen Verteilernetz weiter benutzt werden kann.

Zu den optischen Ein- und Ausgängen ist offenbart, dass diese über optische Elemente geschaffen sind, die sich auf der Kontaktierungsplatte und / oder der Umverteilungsplatte befinden und auf verschiedene Einkoppelmechanismen, z. B. Freistrahlung, Quasifreistrahlung oder Wellenleiter, abgestimmt sind. Als hierfür geeignete optische Elemente sind diffraktive Elemente und refraktive Elemente angegeben. Auch ist angegeben, dass ein Photodetektor oder eine Lichtquelle direkt an der Schnittstelle zum DUT angeordnet sein können, die dann den optischen Ein- oder Ausgang an der Kontaktierungsplatte darstellen.

Darüber hinaus lehrt die vorgenannte US 2006/0109015 A1, dass für Ausführungen der optischen Einkopplung über Freistrahl- oder Quasifreistrahlverbindungen, bei denen das optische Signal durch einen Freiraum zwischen dem optischen Element und der Schnittstelle zum DUT geleitet wird, das optische Signal fokussiert oder kollimiert wird, um eine hohe Einkoppeleffizient des übertragenen Signals zu erreichen. Die Signaleinkopplung unterliegt hier folglich dem Konzept, das Signal möglichst vollständig einzukoppeln.

Zur Signalleitung wird in einem Ausführungsbeispiel der vorgenannten US 2006/0109015 A1 vorgeschlagen, das optische Signal von der der Schnittstelle zum DUT zugewandten Seite der Kontaktierungsplatte durch die Kontaktierungsplatte hindurch zu führen, auf deren Rückseite über ein optisches Element umzulenken und auf einen optischen Empfänger zu führen. Die Führung durch die Kontaktierungsplatte kann erfolgen durch Nutzung einer Wellenlänge für das optische Signal, für die das Material der Kontaktierungsplatte transparent ist, oder durch die physikalische Schaffung eines Weges für das optische Signal, z. B. durch reflektierende metallisierte Durchgangslöcher, optisch dielektrische, photonisch kristalline Wellenleiter oder optische Fasern. Wege in Form von Durchgangslöchern können auch mit optisch transparentem Material verfüllt sein, z. B. einem Polymer.

Nach einem weiteren Ausführungsbeispiel der vorgenannten US 2006/0109015 A1 sind die optischen und die elektrischen Signalleitungen (optisches und elektrisches Verteilernetz) auf separaten Umverteilungsplatten ausgeführt. Es wird vorgeschlagen, die elektrischen Signale von dem DUT zu den Randbereichen der Kontaktierungsplatte zu führen, so dass in der oberhalb der Kontaktierungsplatte angeordneten ersten Umverteilungsplatte die elektrischen Signale oberhalb des Randbereiches eingekoppelt werden. Dadurch kann in der ersten Umverteilungsplatte, in der nur die elektrischen Signale umverteilt werden, eine Öffnung ausgebildet sein, durch die hindurch die optischen Signale in eine darüber angeordnete separate zweite Umverteilungsplatte geführt werden.

Zusammenfassend werden in der vorgenannten US 2006/0109015 A1 eine Vielzahl von Ideen aufgezeigt, wie ein Kontaktierungsmodul, das begründet, z. B. durch den Verschleiß der mechanischen Kontakte für die elektrische Signalübertragung, in eine Kontaktierungsplatte und eine Umverteilungsplatte unterteilt ist, zusätzlich mit optischen Signalleitungen ausgestattet werden könnte. Dabei wird völlig außer Betracht gelassen, dass die für den mechanischen Kontakt der elektrischen Ein- und Ausgänge des Kontaktierungsmoduls zum DUT möglichen Toleranzen nicht auf die optischen Ein- und Ausgänge übertragbar sind.

Während die Übertragung eines stets gleichen elektrischen Signals den mechanischen Kontakt von an dem Kontaktierungsmodul vorhandenen Nadeln mit an dem DUT vorhandenen Kontaktplättchen (Kontaktpads) erfordert, was innerhalb einer vergleichsweise großen Lagetoleranz von einigen µm in alle drei Raumrichtungen gesichert werden kann, wird die Qualität der optischen Signalübertragung bereits bei einer sehr viel kleineren, im Sub-µm-Bereich liegenden Abweichung von seiner Solllage beeinflusst.

Erfolgt, wie in der vorgenannten US 2006/0109015 A1 beschrieben, lediglich eine Optimierung der Koppeleffizienz des optischen Signals durch eine Kollimation oder Fokussierung des optischen Strahls, muss das gesamte Kontaktierungsmodul hochpräzise im Sub-µm-Bereich justiert werden. Andernfalls ist die justageabhängige Wiederholgenauigkeit der Messung nicht ausreichend für die beschriebenen Anwendungen. Das wiederum hat zur Folge, dass das Kontaktierungsmodul nicht die in herkömmlichen elektrischen Waferprobern typischen Justagetoleranzen für die elektrische Kontaktierung im Bereich von einigen µm in X-, Y- und Z-Richtung ausschöpfen kann. Es werden aufwendige und teure Waferprober-Sonderlösungen u. a. mit diversen Stellelementen, wie zum Beispiel Piezostellelementen, und Linearachsen oder Hexapoden benötigt, um das Kontaktierungsmodul hochgenau zum DUT zu justieren.

Ein weiterer kritischer Punkt ist, dass für die saubere elektrische Justage der Nadeln ein sogenannter Overdrive von typisch einigen 10 µm in Z-Richtung eingestellt wird, d. h. dass nach Erstkontakt der Nadeln mit den elektrischen Kontaktpads das Kontaktierungsmodul noch um einen zusätzlichen Betrag in Z-Richtung verfahren wird, um eine saubere und zuverlässige Kontaktierung zu gewährleisten. Abnutzung und Verformung der Nadeln werden i.d.R. durch eine Anpassung des Overdrives während des Betriebes gegenkompensiert. Bei einer einfachen Kollimation oder Fokussierung des optischen Strahls, wie in der vorgenannten US 2006/0109015 A1 beschrieben, darf für eine wiederholgenaue Kopplung der Arbeitsabstand in Z-Richtung jedoch nur im Bereich um Mikrometer schwanken. Damit ist diese Art der optischen Kopplung nicht kompatibel mit etablierten elektrischen Kontaktierungsverfahren.

Die vorgenannte US 2006/0109015 A1 beschreibt zudem lediglich die Weiterleitung des optischen Signals an der Oberfläche der Kontaktierungsplatte (probe substrate) entweder auf der Vorder- oder auf der Rückseite.

Ein nur auf der Vorderseite geführtes optisches Signal muss entweder durch zusätzliche Elemente (Photodioden) in ein elektrisches Signal gewandelt und dann mittels z. B. elektrischer Durchkontaktierung auf die Rückseite geführt werden oder direkt z. B. mittels Fasern auf der Vorderseite ausgekoppelt werden. Für beides ist zwischen dem Kontaktierungsmodul und dem DUT, bauraumbedingt aufgrund eines vorteilhaft geringen Arbeitsabstandes des Kontaktierungsmoduls zum DUT von typisch wenigen 10 µm bis einigen 100 µm, kaum Platz. Je kleiner der Arbeitsabstand, desto höher ist die Effizienz der optischen Kopplung und desto weniger Toleranzen fließen gleichzeitig in die optische Kopplung ein.

Darüber hinaus ist es zielführend, vorhandene Technologien für die elektrische Kontaktierung zu verwenden, wie sogenannte elektronische Cantilever-, Vertical- und MEMS-Probecards. Diese haben in der Regel auch einen geringen Abstand zum DUT und wenig freien Raum zwischen der Probecard und dem DUT.

Ein auf der Rückseite geführtes optisches Signal hat zwangsweise einen sehr hohen optischen Arbeitsabstand, größer der Substratdicke des Kontaktierungsmoduls, und damit die bereits oben beschriebenen Nachteile. Außerdem benötigt es ebenfalls Bauraum an der Rückseite der Kontaktierungsplatte (probe substrate), entweder für die Kontaktierung mit Fasern oder zusätzliche Elemente für die Wandlung in ein elektrisches Signal. Dieser Bauraum ist z. B. bei Verwendung von Vertical Probecards zur elektrischen Kontaktierung nicht vorhanden.

Die Offenlegungsschrift US 2011/0279812 A1 offenbart ein Kontaktierungsmodul zum Testen von Chips mit elektrischen und optischen Ein- und Ausgängen. Der Chip ist auf einem beweglichen Träger aufgenommen, mit dem er sich grob zum Kontaktierungsmodul ausrichten lässt. Die Grobausrichtung erfolgt sensorgesteuert anhand einer Positionsüberwachung des Chips oder der Alignmentmarken des Chips. Die Feinausrichtung des Chips erfolgt in zwei Verfahrensschritten. Im ersten Verfahrensschritt wird überprüft, ob die elektrischen Ein- und Ausgänge in Kontakt zum Kontaktierungsmodul stehen. Der Chip wird dazu mit dem Kontaktierungsmodul angesaugt, sodass die elektrischen Ein- und Ausgänge des Chips mit den elektrischen Kontakten des Kontaktierungsmoduls in Kontakt kommen. Mittels eines Testsignals wird auf eine erfolgreiche Kontaktierung geprüft und bei fehlerhafter Kontaktierung mittels einer wiederholten Grobausrichtung korrigiert. Im zweiten Verfahrensschritt erfolgt die Ausrichtung an den optischen Ein- und Ausgängen. Die optischen Ein- und Ausgänge des Chips können fokussierte oder kollimierte Strahlen mit angepasster Apertur und Fokusposition empfangen oder aussenden. Die optischen Ein- und Ausgänge des Kontaktierungsmoduls verfügen über variable Optiken, mit denen senkrecht auf die Oberfläche der optischen Ein- und Ausgänge fokussierte Strahlen erzeugt werden können, wobei die axiale und seitliche Fokuslage und die Apertur der Strahlen anpassbar sind. Für die Anpassung verfügt die variable Optik über mindestens ein optisches Element mit veränderbarer Brennweite und/oder mindestens ein optisches Element, das beweglich ist. Die axiale Anpassung der Fokuslage erfolgt auf Grundlage von Abstandsmessungen mittels zusätzlicher Abstandssensoren oder von Intensitätsmessungen anhand eines optischen Testsignals. Die seitliche Anpassung der Fokuslage erfolgt auf Grundlage von Intensitätsmessungen, bei denen ein bereits auf die Oberfläche des Chips fokussierter Teststrahl in einer scannenden Relativbewegung gegenüber den optischen Ein- und Ausgängen bewegt wird, bis der Teststrahl optimal in die optischen Ein- und Ausgänge eingekoppelt wird. Die dafür benötigte Zeit kann verkürzt werden, indem die scannende Relativbewegung zunächst mit einem vergrößerten Fokusdurchmesser des Teststrahls ausgeführt wird. Nach der Feinausrichtung erfolgt der Test des Chips mittels spezieller elektrischer und optischer Testsignalsequenzen, wobei beim Testen mehrerer gleichartiger Chips Teile der Grob- und Feinjustage abgespeichert und weiter verwendet werden können.

Die US 2004/0101238 A1 offenbart eine optische Fasereinkopplung. Ein als Strahlquelle verwendeter Laser gibt divergente Laserstrahlung ab, die mittels eines strahlformenden Linsensystems fokussiert wird, wobei der Fokus größer als der Querschnitt der optischen Faser ist. In Ausführungen der Fasereinkopplung sind Mittel vorgesehen, um im Fokus eine gleichmäßige Intensitätsverteilung zu erreichen oder um dem Fokus eine vom Kreis abweichende Form zu geben. Mit der Fasereinkopplung wird eine geringere Empfindlichkeit gegenüber einer ungenauen Ausrichtung der Faser zur Fokussieroptik erreicht.

Aus der US 2004/0022488 A1 ist eine Fasereinkopplung bekannt, die mittels eines diffraktiven oder hybriden diffraktiven und refraktiven Elementes die divergente Laserstrahlung einer Strahlquelle fokussiert. Die Fokussierung erfolgt in ein sich entlang der optischen Achse ausdehnendes Volumen, dessen Durchmesser größer als der Querschnitt der optischen Faser ist, wobei die Intensitätsverteilung im gesamten Volumen konstant ist, sodass das gesamte Volumen zur Ausrichtung der Faser zur Verfügung steht.

In der WO 2013/032954 A1 ist eine freistrahlende optische Datenübertragungsstrecke offenbart. Die Strahlung eines als Sender der Datenübertragungsstrecke verwendeten Clusters aus Halbleiterlasern (VCSEL) wird mit einem Diffusor homogenisiert. Die homogenisierte und sich aufweitende Strahlung wird nach dem Diffusor mittels eines Kollimators kollimiert. Der kollimierte Strahl überbrückt die Datenübertragungsstrecke und ist empfängerseitig auf eine Fokussieroptik gerichtet. Die Fokussieroptik fokussiert den Strahl auf eine Ebene hinter einem Empfänger, sodass der Empfänger stets überstrahlt wird. Die Überstrahlung gestattet, Verkippungen oder seitliche Abweichungen des Senders zur optischen Achse des Empfängers zu tolerieren.

Aus der US 2008/0310852 A1 ist ein Optokoppler bekannt, bei dem ein Freistrahl eines Halbleiterlasers (VCSEL) mit gaußförmiger Intensitätsverteilung zunächst frei divergieren kann, um eine Strahlaufweitung zu erreichen. Der sich aufweitende Strahl wird mittels eines diffraktiven oder refraktiven optischen Elements kollimiert und die Intensitätsverteilung wird über den Strahldurchmesser zu einer flat-top-Verteilung homogenisiert. Der Strahldurchmesser des kollimierten und homogenisierten Strahls ist größer als die Fläche einer Fotodiode des Optokopplers. Der Strahldurchmesser ist so gewählt, dass auch bei einer maximal abweichenden Ausrichtung des Halbleiterlasers zur Fotodiode die Fotodiode stets innerhalb des Strahldurchmessers liegt und der Strahl durch die Homogenisierung an jeder Stelle des Strahldurchmessers die gleiche Intensität aufweist.

Die vorgenannten Publikationen US 2004/0101238 A1, US 2004/0022488 A1, WO 2013/032954 A1 und US 2008/0310852 A1 haben gemeinsam, dass sie zur Einkopplung einer Strahlung in einen optischen Eingang das einzukoppelnde Strahlenbündel mittels optisch abbildender Elemente so formen, dass das Strahlenbündel in einer Einkoppelebene einen Strahlquerschnitt aufweist, der größer ist als der Querschnitt des optischen Eingangs in der Einkoppelebene. Bei den optisch abbildenden Elementen handelt es sich um transparente refraktive oder diffraktive bzw. so kombinierte Elemente.

Alle beschriebenen Lösungsansätze haben gemein, dass nur die lagetolerante Einkopplung von einem optischen Sender in einen optischen Empfänger beschrieben wird. Für die beim Test eines DUTs notwendige lagetolerante Auskopplung eines optischen Signals aus dem DUT wird keine Lösung beschrieben.

Zudem benötigen die vorgenannten Lösungen zur Erfüllung der beschriebenen optischen Funktion einen Abstand des optisch abbildenden Elements zum optischen Eingang im Bereich um 1000 µm oder deutlich mehr, wie er beispielhaft in Fig. 4 in der vorgenannten US 2004/0022488 A1 dargestellt ist. Dieser große Abstand ist unvorteilhaft für eine lagetolerante Auskopplung von Licht aus dem DUT. Hier werden geringstmögliche Abstände, z. B. im Bereich um 100 µm, benötigt. Bezugnehmend auf Fig. 4 und Absatz [0028] der vorgenannten US 2004/0022488 A1 wird zudem für eine Lageänderung von ±5 µm nur eine Wiederholgenauigkeit von ca. 1 dB erreicht; für den Wafer-Level-Test photonisch integrierter Schaltkreise wird jedoch eine um den Faktor 10 verbesserte Messgenauigkeit benötigt.

Die Aufgabe der Erfindung besteht darin, ein lagetoleranzunempfindliches optoelektronisches Kontaktierungsmodul zur Kontaktierung eines optoelektronischen Chips zu schaffen.

Diese Aufgabe wird für ein Kontaktierungsmodul zur zeitlich aufeinanderfolgenden Kontaktierung optoelektronischer Chips zwecks Übertragung von elektrischen und optischen Signalen zwischen jeweils wenigstens einem der optoelektronischen Chips und dem Kontaktierungsmodul, wobei die zeitlich aufeinanderfolgend kontaktierten optoelektronischen Chips und das Kontaktierungsmodul toleranzbedingt in voneinander abweichenden Justierlagen zueinander angeordnet sind, mit im Kontaktierungsmodul angeordneten elektrischen und optischen Signalleitungen, die jeweils einen elektrischen oder optischen Ein- oder Ausgang aufweisen, die als elektrische oder optische Ein- oder Ausgänge am Kontaktierungsmodul jeweils einem elektrischen oder optischen Ein- oder Ausgang des wenigstens einen optoelektronischen Chips zugeordnet sind, wobei die elektrischen Ein- und Ausgänge am Kontaktierungsmodul jeweils durch Kontaktnadeln gebildet sind, die zur Übertragung der elektrischen Signale jeweils mit einem der elektrischen Ein- bzw. Ausgänge des wenigstens einen optoelektronischen Chips, die jeweils durch ein elektrisches Kontaktplättchen gebildet sind, in jeder der Justierlagen mechanisch in Kontakt stehen, und die optischen Ein- und Ausgänge am Kontaktierungsmodul mit den optischen Ein- und Ausgängen des wenigstens einen optoelektronischen Chips jeweils paarweise einen optischen Freistrahlbereich zur Übertragung der optischen Signale begrenzen, dadurch gelöst, dass die von dem Kontaktierungsmodul zu dem wenigstens einen optoelektronischen Chip übertragenen optischen Signale aufgrund der Länge des jeweiligen gebildeten Freistrahlbereiches von wenigen 10 µm bis einigen 100 µm und einer wenigstens leicht divergenten Abstrahlung des optischen Signals Sₒ jeweils eine größere Fläche eines der optischen Eingänge E_{oC} an dem wenigstens einen Chip ausleuchten als die Öffnung des jeweiligen optischen Eingangs E_{oC} an dem wenigstens einen Chips groß ist, so dass die optischen Eingänge des wenigstens einen optoelektronischen Chips in jeder der Justierlagen überstrahlt werden und dass das Kontaktierungsmodul ein Elektronikmodul mit den Kontaktnadeln und einer Leiterplatte, in dem die elektrischen Signalleitungen geführt sind, und ein Optikmodul mit einem Optikblock enthält, in dem die optischen und/oder elektrischen Signalleitungen geführt sind, die zu den optischen Ein- und Ausgängen E_{oK}, A_{oK} am Kontaktierungsmodul führen, wobei die Leiterplatte und der Optikblock zueinander justiert fest angeordnet sind und dass die optischen Signalleitungen im Optikblock integrierte Wellenleiter sind.

Vorzugsweise bestehen die Leiterplatte und der Optikblock aus verschiedenem Material, und die elektrischen und optischen Signalleitungen voneinander unabhängig durch verschiedene Technologienhergestellt wurden.

Vorzugsweise entspricht die Intensitätsverteilung im Strahlquerschnitt des optischen Signals einer Gaußverteilung.

Es ist vorteilhaft, wenn die Intensitätsverteilung im Strahlquerschnitt des optischen Signals einer TOP-Hat-Verteilung entspricht.

Günstig ist der Optikblock in seiner Dimension und Geometrie, einschließlich Durchbrüchen bzw. Öffnungen, so ausgeführt, dass alle am Elektronikmodul vorhandenen Kontaktnadeln an dem Optikblock vorbei, um ihn herum und/oder gegebenenfalls durch in ihm ausgebildete Öffnungen hindurch mit dem Chip (2) in Kontakt stehen.

Erfindungsgemäß liegen die Ein- oder Ausgänge der Wellenleiter, die die optischen Ein- oder Ausgänge am Kontaktierungsmodul bilden, im Inneren des Optikblockes und ist jedem der Ein- oder Ausgänge ein integrierter Spiegel vorgeordnet, der die vom Wellenleiter kommenden optischen Signale in eine zur Einkopplung in den wenigstens einen Chip benötigte Richtung umlenkt.

Vorteilhafterweise werden die von dem wenigstens einen optoelektronischen Chip übertragenen optischen Signale vollständig in die optischen Eingänge am Kontaktierungsmodul in jeder der Justierlagen eingekoppelt.

Bevorzugt münden die Wellenleiter jeweils in einen Taper, der am Eingang des Wellenleiters einen auf einen Wellenleiterquerschnitt angepassten Querschnitt aufweist und die gesamte Strahlungsintensität des optischen Signals in jeder der Justierlagen vollständig in den Wellenleiter lenkt, wobei der Strahlquerschnitt des in den Taper einfallenden optischen Signals kleiner als eine Eintrittsöffnung des Tapers ist.

Es ist von Vorteil, wenn der Spiegel als ein Hohlspiegel ausgeführt ist.

Vorzugsweise münden die Wellenleiter jeweils in eine vorgeordnete Wellenleitergruppe, deren Enden gemeinsam einen der optischen Eingänge bilden, der in jeder Justierlage vollständig überstrahlt wird, sodass ein größerer Anteil der Signalintensität als nur in einen Wellenleiter eingekoppelt wird.

Die Erfindung wird nachfolgend anhand von Ausführungsbeispielen und Zeichnungen näher erläutert. Hierzu zeigen
- Fig. 1: ein erstes Blockschaltbild für die Signalübertragung zwischen einigen Chips eines Wafers und der Testapparatur über ein Kontaktierungsmodul,
- Fig. 2: ein zweites Blockschaltbild für die Signalübertragung zwischen einigen Chips eines Wafers und der Testapparatur,
- Fig. 3a-b: ein erstes Ausführungsbeispiel eines Kontaktierungsmoduls, ausgelegt zur Kontaktierung eines einzelnen Chips,
- Fig. 4: ein zweites Ausführungsbeispiel eines Kontaktierungsmoduls,
- Fig. 5a-b: die Einkopplung eines optischen Signals in das Optikmodul über eine Fotodiode in zwei verschiedenen Justagepositionen,
- Fig. 5c-e: drei mögliche Montagepositionen einer Fotodiode im Optikmodul,
- Fig. 6a-d: verschieden gestaltete Eingänge von Wellenleitern im Optikmodul,
- Fig. 7: mehrere, einer Fotodiode vorgeordnete Wellenleiter im Optikmodul,
- Fig. 8: eine Einkopplung der optischen Signale in den Optikblock von oben,
- Fig. 9: einen Optikblock zur Kontaktierung von zwei Chips,
- Fig. 10a-b: ein Kontaktierungsmodul mit Vertikal-Nadeln und
- Fig. 11: ein Kontaktierungsmodul zur Kontaktierung von vier Chips.

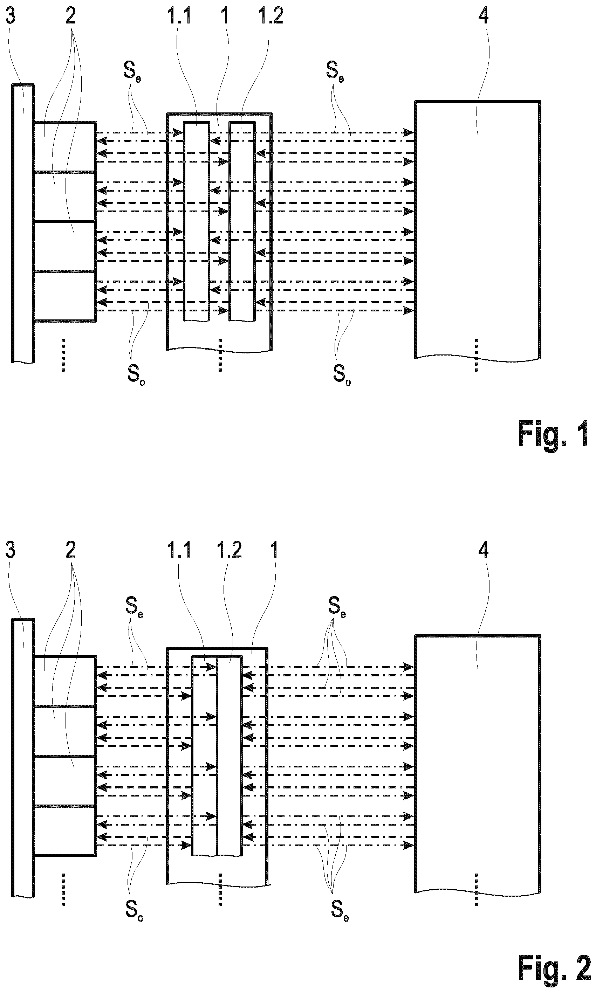

Ein erfindungsgemäßes Kontaktierungsmodul 1 wird, gleich aus dem Stand der Technik bekannter Kontaktierungsmodule, wie in **Fig. 1** in einem Blockschaltbild dargestellt, zwischen einer Waferplattform 3, z. B. einem Waferprober, auf dem ein Wafer mit zu testenden optoelektronischen Chips 2 fixiert ist, und einer Testapparatur 4, zur Generierung und Auswertung von optischen Signalen Sₒ und elektrischen Signalen Sₑ, angeordnet. Das Kontaktierungsmodul 1 stellt die signaltechnische Verbindung zwischen den individuellen Schnittstellen des einen oder der mehreren zeitgleich zu testenden optoelektronischen Chips 2 (nachfolgend zur Vereinfachung der Beschreibung: ein Chip 2) und den gerätetechnisch vorgegebenen Schnittstellen der Testapparatur 4 her. Bei den Schnittstellen handelt es sich jeweils um elektrische oder optische Ein- und Ausgänge, aus denen bzw. in die die elektrischen oder optischen Signale Sₑ, Sₒ ein- bzw. ausgekoppelt werden und über elektrische oder optische Signalleitungen 1.1.1.1, 1.2.1.1 hin- bzw. weggeleitet werden.

Das Kontaktierungsmodul 1 ist in einer Weise über elektrische Schnittstellen mit der Testapparatur 4 verbunden, wie sie aus dem Stand der Technik bekannt ist, wobei es sich bevorzugt um Steckverbindungen handelt. Optische Schnittstellen mit der Testapparatur 4 werden bevorzugt über Glasfaserverbindungen mit zugehörigen Faser- oder Multifasersteckern realisiert.

Zur Kontaktierung der Schnittstellen des Chips 2 sind das Kontaktierungsmodul 1 und die Waferplattform 3 zueinander justiert angeordnet. Dabei können für eine zeitlich aufeinanderfolgende Kontaktierung der Chips 2 toleranzbedingt unterschiedliche Justierlagen eingenommen werden. Die für den optoelektronischen Test des Chips 2 erforderliche Justiergenauigkeit hängt davon ab, in welchen Toleranzgrenzen noch eine sichere Kontaktierung der Schnittstellen, das heißt eine wiederholgenaue Signalübertragung, gewährleistet werden kann.

Gleich dem Stand der Technik sind die elektrischen Ein- und Ausgänge E_{eK}, A_{eK} am Kontaktierungsmodul 1 jeweils durch Kontaktnadeln 1.1.2 gebildet, die zur Übertragung der elektrischen Signale Sₑ jeweils mit einem der elektrischen Ein- bzw. Ausgänge E_{eC}, A_{eC} des optoelektronischen Chips 2, die jeweils durch ein elektrisches Kontaktplättchen 2.1 gebildet sind, mechanisch in Kontakt stehen. Die für eine sichere elektrische Kontaktierung erforderlichen Toleranzgrenzen sind, wie in der Beschreibung des Standes der Technik ausführlich dargelegt, im Vergleich zu für die optische Kontaktierung benötigten Toleranzen groß.

Die optischen Ein- und Ausgänge E_{oK}, A_{oK} am Kontaktierungsmodul 1 begrenzen zur Übertragung der optischen Signale Sₒ mit den optischen Ein- und Ausgängen E_{oC}, A_{oC} des optoelektronischen Chips 2 jeweils paarweise einen hier sogenannten Freistrahlbereich. Als Freistrahlbereich ist ein Bereich zu verstehen, entlang dessen ein optisches Signal Sₒ, auch optischer Strahl, nicht in einem optischen Signalleiter, im Speziellen in einem Wellenleiter, geführt wird. Dabei kann der Strahl völlig unbeeinflusst nur in dem Medium Luft über den Abstand zwischen dem Chip 2 und dem Kontaktierungsmodul 1 oder auch zusätzlich in dem Medium des Kontaktierungsmoduls 1 geführt werden, wenn dessen optische Ein- oder Ausgänge E_{oK}, A_{oK} nicht unmittelbar an einer Außenfläche des Kontaktierungsmoduls 1 liegen. In diesem hier sogenannten Freistrahlbereich können am Kontaktierungsmodul 1 ausgebildet Strahlformungs- und Strahlumlenkungselemente vorhanden sein, um einerseits den in das Kontaktierungsmodul 1 einstrahlenden Strahl zum Wellenleitereingang zu lenken und / oder den Strahl geometrisch bzw. in seiner Intensitätsverteilung zu formen und andererseits den das Kontaktierungsmodul 1 verlassenden Strahl für die Einkopplung in den Chip 2 aufzubereiten.

Um eine wiederholgenaue Übertragung der optischen Signale Sₒ zu gewährleisten, das heißt die in die optischen Eingänge E_{oC}, E_{oK} des Chips 2 und am Kontaktierungsmodul 1 jeweils eingekoppelte Signalintensität überschreitet eine vorgegebene Schwankungsbreite nicht, werden erfindungsgemäß alternativ verschiedene Maßnahmen zur Ausführung des Freistrahlbereiches, einschließlich der optischen Ein- und Ausgänge E_{oK}, A_{oK} am Kontaktierungsmodul 1 getroffen, die in verschiedenen Ausführungsbeispielen für ein erfindungsgemäßes Kontaktierungsmodul 1 beschrieben werden.

Dabei sind in allen Ausführungsbeispielen entweder die optischen Ausgänge A_{oK} am Kontaktierungsmodul 1 so zu den jeweils zugehörigen optischen Eingängen E_{oC} des optoelektronischen Chips 2 angeordnet, dass aufgrund der Länge des jeweiligen gebildeten Freistrahlbereiches die optischen Eingänge E_{oC} des optoelektronischen Chips 2 in jeder der Justierlagen von den optischen Signalen Sₒ überstrahlt werden, was bei einer wenigstens leicht divergenten Abstrahlung des optischen Signals Sₒ möglich ist, und / oder es sind an oder zwischen den optischen Ausgängen A_{oK} am Kontaktierungsmodul 1 und den optischen Eingängen E_{oC} des optoelektronischen Chips 2 im jeweiligen Freistrahlbereich optische Mittel vorhanden, die das optische Signal Sₒ formen, sodass die optischen Eingänge E_{oC} am Chip 2 in jeder der Justierlagen von den optischen Signalen Sₒ überstrahlt werden.

Darüber hinaus sind alle oder ein Teil der optischen Eingänge E_{oK} am Kontaktierungsmodul 1 so zu den jeweils zugehörigen optischen Ausgängen A_{oC} des optoelektronischen Chips 2 angeordnet, dass aufgrund der Länge des jeweiligen gebildeten Freistrahlbereiches die optischen Eingänge E_{oK} am Kontaktierungsmodul 1 in jeder der Justierlagen jeweils von den optischen Signalen Sₒ überstrahlt werden. Alternativ sind alle oder ein Teil der optischen Eingänge E_{oK} am Kontaktierungsmodul 1 so zu den jeweils zugehörigen optischen Ausgängen A_{oC} des optoelektronischen Chips 2 angeordnet, dass aufgrund der Länge des jeweiligen gebildeten Freistrahlbereiches die optischen Eingänge E_{oK} am Kontaktierungsmodul in jeder der Justierlagen jeweils von den optischen Signalen Sₒ überstrahlt werden.

Das Kontaktierungsmodul 1 kann gegenständlich aus einer oder mehreren zueinander definiert angeordneten Baugruppen bestehen. Auch kann es sich um ein monolithisches Bauteil handeln, an dem zur Kontaktierung des Chips 2 dem Chip 2 zugewandt die elektrischen und optischen Ein- und Ausgänge E_{eK}, E_{oK}, A_{eK}, A_{oK} angeordnet sind, die jeweils über eine elektrische oder optische Signalleitung 1.1.1.1, 1.2.1.1 in Form eines Verteilernetzes zu Ein- und Ausgängen führen, die mit den Schnittstellen der Testapparatur 4 verbunden werden. Das Kontaktierungsmodul 1 kann ebenso gleich dem Stand der Technik gegenständlich eine Kontaktplatte zur optischen und elektrischen Kontaktierung des Chips 2 und eine oder mehrere Verteilerplatten zur Signalverteilung enthalten. Andere Ausführungen sind denkbar, bei denen die Ein- und Ausgänge E_{eK}, E_{oK}, A_{eK}, A_{oK} am Kontaktierungsmodul 1 erfindungsgemäß ausgeführt sind.

Besonders vorteilhaft enthält das Kontaktierungsmodul 1 ein Elektronikmodul 1.1 mit einer Leiterplatte 1.1.1, die bevorzugt einer aus dem Stand der Technik bekannten Cantilever- oder Vertical Probecard entspricht und an der die elektrischen Ein- und Ausgänge E_{eK}, A_{eK} angeordnet sind, und ein Optikmodul 1.2, mit einem Optikblock 1.2.1, an dem die optischen Ein- und Ausgänge E_{oK}, A_{oK} angeordnet sind, die hier durch die Ein- und Ausgänge im Optikblock 1.2.1 integrierter Wellenleiter, die die optischen Signalleitungen 1.2.1.1 bilden, oder in einem Sonderfall durch die lichtempfindliche Fläche 6.1 einer Fotodiode 6 gebildet sind.

Die elektrischen Signalleitungen 1.1.1.1 sowie die elektrischen Ein- und Ausgänge E_{eK}, A_{eK} am Kontaktierungsmodul 1 und die optischen Signalleitungen 1.2.1.1 mit ihren optischen Ein- und Ausgängen E_{oK}, A_{oK} können so voneinander unabhängig durch unterschiedliche Herstellungsverfahren hergestellt werden. Damit alle Ein- und Ausgänge, egal ob optisch oder elektrisch, eine gemeinsame Anordnung bilden, die relativ zu dem zu testenden Chip 2 justiert werden kann, sind die Leiterplatte 1.1.1 und der Optikblock 1.2.1 zueinander justiert fest angeordnet.

Der Optikblock 1.2.1 ist bevorzugt monolithisch ausgeführt und ist aus einem anderen Material als die Leiterplatte 1.1.1 gefertigt, nämlich aus einem Material, das für die Herstellung von optischen Signalleitungen 1.2.1.1 in Form von integrierten Wellenleitern geeignet ist. Zur Herstellung der optischen Signalleitungen 1.2.1.1 im Optikblock 1.2.1, in Form von Wellenleitern, können Technologien eingesetzt werden, die es ermöglichen, diese sehr präzise mit nur geringen Toleranzen zueinander herzustellen. Hierzu zählen laserbasierte Direktschreibverfahren. Diese erlauben zum einen durch die Veränderung der optischen Eigenschaften des Substratmaterials des Optikblockes 1.2.1 das Einbringen von Wellenleitern und zum anderen durch eine lokale Veränderung der Struktur des Substratmaterials eine lokale Modifikation des nasschemischen Ätzverhaltens des Substratmaterials und damit das Erstellen von optischen Elementen, wie Spiegeln, durch anschließendes Ätzen direkt in ein Substratmaterial aus Glas mit einer Submikrometer-Präzisionsgenauigkeit. Dabei sind Lage und Form der eingebrachten Elemente direkt durch eine Variation der Schreibparameter des Lasers flexibel anpassbar.

Im Unterschied zu dem konzeptionell die optischen Signale Sₒ (Strich-Linie) zur Testapparatur 4 übertragenden Kontaktierungsmodul 1 nach **Fig. 1** werden in einem Kontaktierungsmodul 1 nach **Fig. 2** konzeptionell von dem Chip 2 kommende optische Sₒ Signale in elektrische Signale Sₑ (Strich-Punkt-Linie) gewandelt, die zur Testapparatur 4 geleitet werden. Die optischen Eingänge E_{oK} am Kontaktierungsmodul 1 werden dann vorteilhaft durch einen optischen Empfänger gebildet. Günstig ist, dass in diesem Fall nur elektrische Signale Sₑ zur Testapparatur 4 geführt werden müssen, was den Aufwand zur Anpassung einer herkömmlichen Testapparatur 4 zum Testen rein elektronischer Chips an die Prüfaufgabe für optoelektronische Chips 2 verringert.

Bei einer vorteilhaften Ausführung des Kontaktierungsmoduls 1 mit einem Elektronikmodul 1.1 und einem Optikmodul 1.2 mit Optikblock 1.2.1 ist der Optikblock 1.2.1 vorteilhaft in seiner Dimension und Geometrie, einschließlich Durchbrüchen bzw. Öffnungen, so ausgeführt, dass alle am Elektronikmodul 1.1 vorhandenen Kontaktnadeln 1.1.2 an dem Optikblock 1.2.1 vorbei, um ihn herum und / oder gegebenenfalls durch in ihm ausgebildete Öffnungen hindurch mit dem Chip 2 in Kontakt stehen können. Das ermöglicht die Integration aller optischen Schnittstellen in einem monolithischen Block.

Sind die Berührungskontakte an den elektrischen Schnittstellen hergestellt, weist der Optikblock 1.2.1 nur einen kleinen definierten Abstand zum Chip 2 auf.

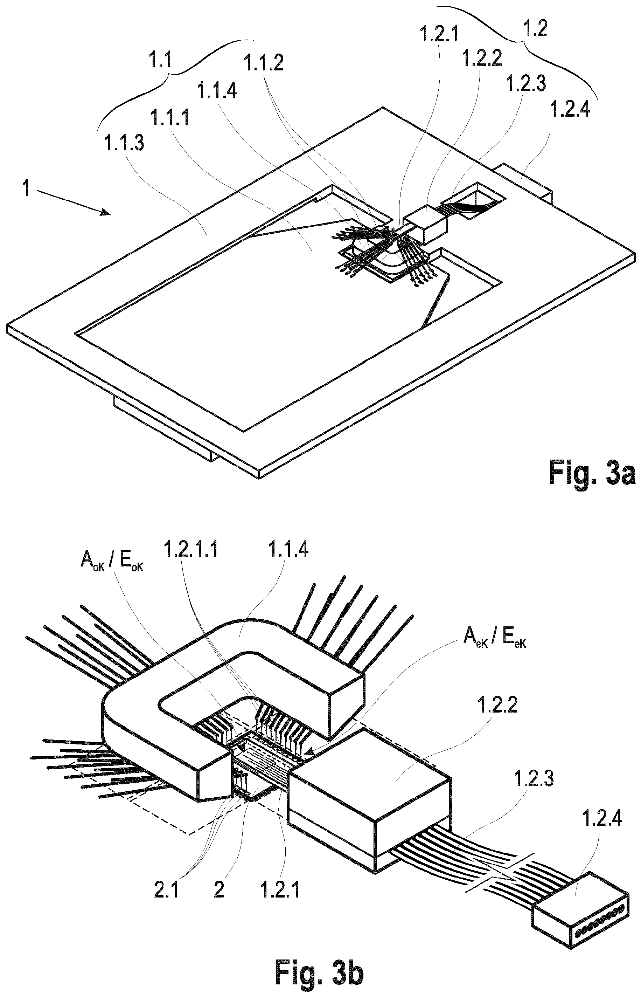

Ein erstes Ausführungsbeispiel eines Kontaktierungsmoduls 1 ist in **Fig. 3a** und in **Fig. 3b** gezeigt.

Das Kontaktierungsmodul 1 enthält ein Elektronikmodul 1.1 und ein Optikmodul 1.2. Das Elektronikmodul 1.1 entspricht in seiner technischen Ausführung einem herkömmlichen Kontaktierungsmodul für rein elektronische Chips. Es enthält eine Leiterplatte 1.1.1, Kontaktnadeln 1.1.2, hier beispielhaft als Cantilever-Nadeln ausgeführt, und eine der Leiterplatte 1.1.1 zugeordnete Trägerplatte 1.1.3. Die elektrische Kontaktierung erfolgt über das Elektronikmodul 1.1 durch physikalischen Kontakt der Kontaktnadeln 1.1.2 mit den elektrischen Kontaktplättchen 2.1 des Chips 2.

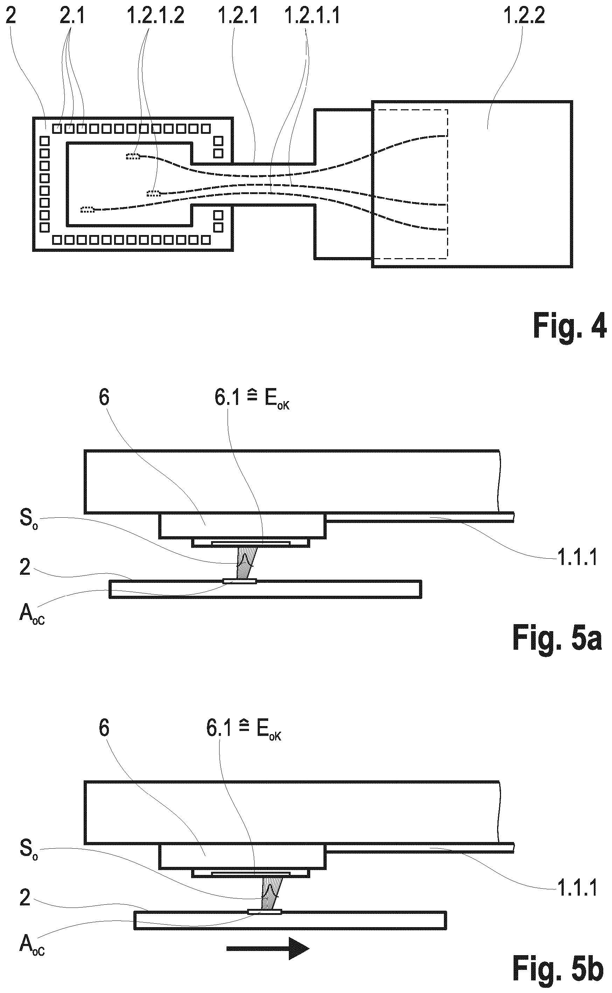

Das Optikmodul 1.2 besteht aus einem Optikblock 1.2.1 mit optischen Signalleitungen 1.2.1.1, jeweils in Form eines Wellenleiters, oder in einem Sonderfall auch in Form mehrerer Wellenleiter, die innerhalb des Optikblocks 1.2.1 dann zu einem Wellenleiter zusammengeführt werden, und jeweils einem einem Wellenleiter vorgeordneten integrierten Spiegel 1.2.1.2 (siehe z. B. Fig. 4), einem V-Nuten aufweisenden Faserhalter 1.2.2, sowie Glasfasern 1.2.3 und Einzel-Fasersteckern bzw. einem Multi-Faserstecker 1.2.4. Die Wellenleiter 1.2.1.1 sind mit einem Laserdirektschreibverfahren und die Spiegel 1.2.1.2 mit einem laserunterstützten Ätzverfahren hergestellt. Folglich werden die Wellenleiter infolge des Eintrages von Laserenergie durch örtlich begrenztes modifiziertes Substratmaterial gebildet, welches sich insbesondere durch eine lokale Brechzahlmodifikation gegenüber der Brechzahl des Substratmaterials auszeichnet. Die Spiegel 1.2.1.2 werden durch Grenzflächen von geätzten Ausnehmungen in dem Substratmaterial gebildet. Das Substratmaterial des Optikblocks 1.2.1 ist Glas, bevorzugt Borofloatglas, und weist eine Dicke im Bereich von einigen 100 µm bis einigen Millimetern, bevorzugt 0,5 - 1 mm, auf. Die optische Kontaktierung / Kopplung erfolgt ohne direkten Kontakt mit dem Chip 2 über einen Abstand zwischen dem Chip 2 und dem Kontaktierungsmodul 1. Die Glasfasern 1.2.3 und Wellenleiter 1.2.1.1 können sowohl auf Monomode- als auch Multimodebetrieb und für den Wellenlängenbereich von sichtbarem Licht bis zum IR-Bereich ausgelegt sein. Die bevorzugte Ausführungsform ist der Monomodebetrieb im Wellenlängenbereich des O- bis L-Bandes. Ohne zusätzliche Strahlformungselemente im Strahlengang an oder zwischen den optischen Ein- und Ausgängen erfolgt die Kopplung der im Optikblock 1.2.1 in den Wellenleitern 1.2.1.1 geführten optischen Signale Sₒ jeweils über einen Spiegel 1.2.1.2 an einem der optischen Ausgänge A_{oK} des Optikmoduls in einen optischen Eingang E_{oC} des Chips 2 mit einem gaußförmigen Modenprofil im Strahlquerschnitt des optischen Signals Sₒ. Der Arbeitsabstand zwischen dem Kontaktierungsmodul 1 und dem Chip 2 beträgt typisch wenige 10 µm bis einige 100 µm. In einer bevorzugten Variante ist der Arbeitsabstand bewusst so gewählt, dass mit dem Strahlquerschnitt eine deutlich größere Fläche beleuchtet wird, als die Öffnung des optischen Eingangs E_{oC}, die hier dem Modendurchmesser des Grating Couplers gleichgesetzt wird, der zur Einkopplung des optischen Signals Sₒ am optischen Eingang E_{oC} vorhanden ist, groß ist. Durch die größer beleuchtete Fläche, das heißt der optische Eingang E_{oC} wird überstrahlt, verringert sich zwar die Effizienz der Einkopplung, aber die Justageempfindlichkeit wird reduziert. Dies erlaubt eine höhere Wiederholgenauigkeit der Messungen bei gegebener Justagegenauigkeit und führt zu einer nur geringen Schwankungsbreite der eingekoppelten Signalintensität. Ein bevorzugter Arbeitsabstand beträgt z. B. 100 µm. Die Einkopplung ist also weniger auf Effizienz, sondern in erster Linie auf eine möglichst stark reduzierte Justageempfindlichkeit optimiert.

Die von der Testapparatur 4 kommenden optischen Signale Sₒ werden mittels Faser- oder Multifasersteckverbindungen in die Glasfasern 1.2.3 und dann seitlich in die Wellenleiter 1.2.1.1 des Optikblocks 1.2.1 eingekoppelt. Die Verbindungsflächen zwischen dem Faserhalter 1.2.2 und dem Optikblock 1.2.1 sind abgeschrägt (nicht dargestellt), z. B. mit einem Winkel von 8° zur Senkrechten zur Verlaufsrichtung der Glasfasern 1.2.3, um Rückreflexionen zu vermeiden. Die vertikale Kopplung zum Chip 2 erfolgt mittels der Spiegel 1.2.1.2, die jeweils, in den Fig. 3a und 3b nicht dargestellt, an den Enden der Wellenleiter im Optikblock 1.2.1 vorhanden sind. In einer bevorzugten Variante arbeiten die Spiegel 1.2.1.2 in Totalreflexion.

Die dem Chip 2 zugewandte Seite des Faserhalters 1.2.2 steht nicht über die dem Chip 2 zugewandte Seite des Optikblocks 1.2.1 hinaus. Dies ist aufgrund des geringen Arbeitsabstandes wichtig, um eine Kollision des Optikmoduls 1.2 mit dem Chip 2 während der Kontaktierung zu vermeiden.

Das verwendete Verfahren zur Herstellung der Spiegel 1.2.1.2 und der Wellenleiter erlaubt:
- die submikrometergenaue Positionierung aller Spiegel 1.2.1.2 und Wellenleiter 1.2.1.1 und damit der optischen Schnittstellen innerhalb eines Optikblocks 1.2.1 aus einem Substrat zueinander,
- die freie Positionierung der Spiegel 1.2.1.2 und Wellenleiter innerhalb des Substrates,
- Abstände (Pitches) der Spiegel 1.2.1.2 und damit Abstände der optischen Aus- und Eingänge von 250 µm, 127 µm und kleiner,
- durch Anpassung des Spiegelwinkels eine Anpassung des Strahlwinkels auf die verschiedenen Abstrahlwinkel des optischen Signals Sₒ auf an den optischen Eingängen E_{oC} des Chips 2 angeordnete optische Koppelelemente, z. B. einem Grating Coupler mit Abstrahlprofil typ. 8-20°)
- eine schnelle, flexible und kostengünstige Änderung der Position der optischen Schnittstellen für Kontaktierungsmodule 1 angepasst an andere Chips 2.

Das Elektronikmodul 1.1 enthält eine Leiterplatte 1.1.1, eine Trägerplatte 1.1.3, einen Keramikträger 1.1.4 und daran aufgeklebte Kontaktnadeln 1.1.2, hier Cantilever-Nadeln. Das Optikmodul 1.2 ist am Elektronikmodul 1.1 bevorzugt über z. B. drei Fixierpunkte an der Trägerplatte 1.1.3, die vorteilhaft einen Metallrahmen darstellt, angeklebt. Grundsätzlich kann der Optikblock 1.2.1 auch direkt an der Leiterplatte 1.1.1 befestigt sein. Die Befestigung des Optikmoduls 1.2 an der Trägerplatte 1.1.3, an der auch die Leiterplatte 1.1.1 befestigt ist, ist aus folgendem Grund vorteilhaft:
- Um einen definierten optischen Arbeitsabstand des Optikmoduls 1.2 zum Chip 2 bei gleichzeitiger sicherer elektrischer Kontaktierung durch die Kontaktnadeln 1.1.2 zu erreichen, müssen die Kontaktnadeln 1.1.2 und der Optikblock 1.2.1 des Optikmoduls 1.2 in Z-Richtung sehr genau zueinander ausgerichtet sein. Zudem soll bei mechanischer Belastung des Kontaktierungsmoduls 1 durch das Andrücken der Kontaktnadeln 1.1.2 eine maximal geringe Verformung des Kontaktierungsmoduls 1 erfolgen. Beides wird durch die Verwendung eines Metallrahmens, zum Tragen der Leiterplatte 1.1.1 und zur Befestigung des Optikblocks 1.2.1, gewährleistet.
- Bei der Fertigung des Elektronikmoduls 1.1, z. B. mit Cantilever-Nadeln als Kontaktnadeln 1.1.2, wird die Z-Höhe der Nadeln i.d.R. auf die Einspannpunkte des Kontaktierungsmoduls 1 mit festem Bezug zur Waferplattform 3 referenziert. Bei einem Metallrahmen als Trägerplatte 1.1.3 liegen diese Referenzpunkte auf dem Metallrahmen, in den die Fixierpunkte für das Optikmodul 1.2 mit hoher Präzision integriert werden. Somit kann das Optikmodul 1.2 durch positionsgenaues Kleben auf die Fixierpunkte in Z-Richtung exakt planparallel und genau in Bezug auf die Referenzebene der Spitzen der Kontaktnadeln 1.1.2 montiert werden. Eine planparallele Montage des Optikmoduls 1.2 zum Elektronikmodul 1.1 verhindert zudem, dass das Optikmodul 1.2 mit dem Chip 2 im Betrieb, während der Kontaktierung, aufgrund des geringen Arbeitsabstandes kollidiert.

Das erste Ausführungsbeispiel eines Kontaktierungsmoduls 1, gemäß der **Fig. 3a und 3b****,** ermöglicht die elektrische Kontaktierung genau eines Chips 2 mittels des Elektronikmoduls 1.1 an drei Seiten im Randbereich des Chips 2. Die vierte Seite im Randbereich des Chips 2 wird als Zugang für das Optikmodul 1.2 verwendet.

In einem zweiten Ausführungsbeispiel, dargestellt in **Fig. 4****,** sind die Form des Optikblocks 1.2.1 und das Routing der optischen Signalleitungen 1.2.1.1, in Form integrierter Wellenleiter, auf eine Layoutkonfiguration der optischen und elektrischen Schnittstellen des Chips 2 angepasst, bei der die elektrischen Schnittstellen an allen Seiten im Randbereich des Chips 2 und die optischen Schnittstellen in einem mittleren Bereich angeordnet sind. Die Darstellung in **Fig. 4** ist lediglich ein Beispiel für das flexible Routing der Wellenleiter im Optikblock 1.2.1 bei Beibehaltung von vernachlässigbaren Lagetoleranzen der Wellenleiter und Spiegel 1.2.1.2 zueinander.

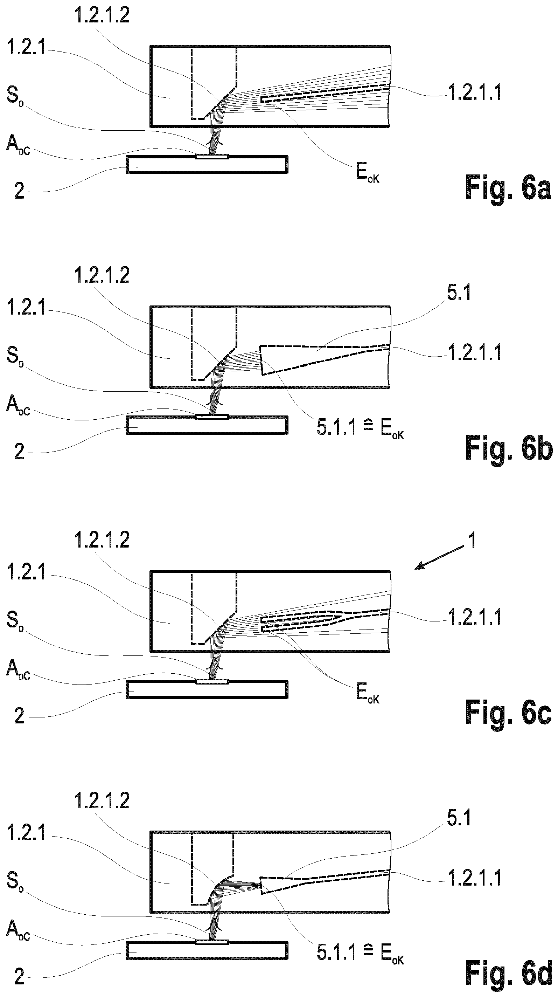

Bei dem ersten und zweiten Ausführungsbeispiel eines Kontaktierungsmoduls 1, gemäß den **Fig. 3a, 3b** **und** **4****,** werden die vom Chip 2 kommenden optischen Signale Sₒ in die optischen Signalleitungen 1.2.1.1, in Form von Wellenleitern, eingekoppelt, nachdem sie jeweils frei in den Optikblock 1.2.1 eingestrahlt und über einen Spiegel 1.2.1.2 zu einem der Wellenleiter hin umgelenkt wurden. Die aus den Wellenleitern austretenden Signale werden entsprechend jeweils frei durch den Optikblock 1.2.1 geführt und über einen Spiegel 1.2.1.2 zum Chip 2 hin umgelenkt und in die optischen Eingänge E_{oC} des Chips 2 eingekoppelt. Unterschiedliche Ausführungen des Freistrahlweges werden später anhand der **Fig. 6a****-d** und **Fig.** 7-11 erläutert.

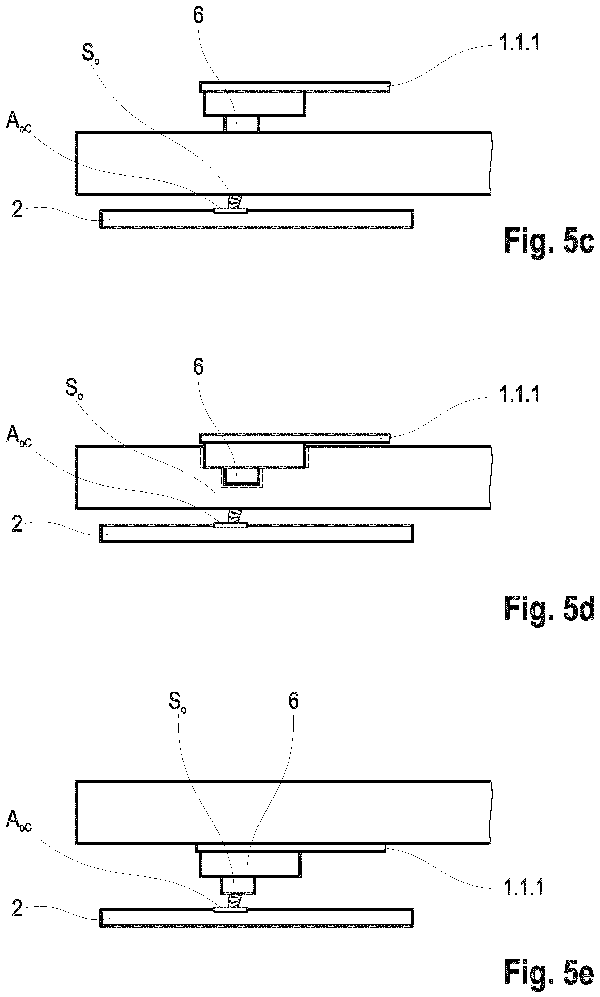

Alternativ kann die Einkopplung der optischen Signale Sₒ in die Signalleitungen des Optikmoduls 1.2 gemäß einem dritten Ausführungsbeispiel, wie in den **Fig. 5a** **- b** gezeigt, auch über Fotodioden 6 erfolgen, deren lichtempfindliche Flächen 6.1 dann im Sinne dieser Beschreibung optische Eingänge E_{oK} der Signalleitungen im Optikmodul 1.2 darstellen. In diesem Sonderfall sind die optischen Eingänge E_{oK} im Optikmodul 1.2 im weitesten Sinne mit elektrischen Signalleitungen 1.1.1.1 verbunden. Dabei ist entscheidend, dass der Arbeitsabstand des Chips 2 zu den Fotodioden 6 und die Größe der lichtempfindlichen Fläche 6.1 der Fotodioden 6 so kombiniert werden, dass die gewünschte Justageinsensitivität erreicht wird. Dies ist der Fall, wenn die lichtempfindliche Fläche 6.1 der Fotodioden 6 beim gewählten Arbeitsabstand groß genug ist, dass bei jeder toleranzbedingten Justageposition des Chips 2 zum Kontaktierungsmodul 1, zwei davon sind in den **Fig. 5a - 5b** gezeigt, die von der Fotodiode 6 erfasste Intensität des optischen Signals Sₒ nur zu einer für die Messung tolerierbaren Änderung führt.

Vorzugsweise wird der Abstand der Fotodioden 6 zum Chip 2 so gering wie möglich gewählt, um eine hohe Effizienz bei gleichzeitig größtmöglicher Justageinsensitivität zu erhalten. Um jedoch den Arbeitsabstand für die Auskopplung aus dem Chip 2 (Mindestlänge des optischen Freistrahlbereichs zwischen dem optischen Ausgang A_{oC} des Chips 2 und dem optischen Eingang E_{oK} am Kontaktierungsmodul 1) unabhängig von dem für die Einkopplung in den Chip 2 benötigten Arbeitsabstand (Mindestlänge des optischen Freistrahlbereiches zwischen dem optischen Ausgang A_{oK} am Kontaktierungsmodul 1 und dem optischen Eingang E_{oC} des Chips 2) variieren zu können, zeigen **Fig. 5c****-e** drei prinzipiell mögliche Montagepositionen einer der Fotodioden 6 im Optikmodul 1.2 an der Oberseite, in einer eingebrachten Vertiefung an der Ober- oder Unterseite und an der Unterseite.

Die Kontaktierung der Fotodioden 6 kann z. B. mittels Flipchiplöten oder Bonden direkt auf einem elektrischen Kabel, z. B. Flexkabel, erfolgen oder zur zusätzlichen Umverteilung und Stabilisierung noch einen Halter aus Keramik verwenden. Eine weitere Alternative ist die direkte Montage der Fotodioden 6 auf dem Optikblock 1.2.1. Das Flexkabel kann direkt daneben positioniert und z. B. geklebt werden, eine Kontaktierung erfolgt durch Bonden. Vorzugsweise werden in der Telekommunikation gebräuchliche High-Speed-Fotodioden aus InGaAs/InP für den Wellenlängenbereich des O- bis L-Bandes verwendet. Deren Empfindlichkeit ist über die gesamte Diodenfläche sehr homogen.

Nachfolgend werden an weiteren Ausführungsbeispielen, die mit den vorgenannten wahlweise kombiniert werden können, verschiedene Maßnahmen gezeigt, mit denen das optische Signal Sₒ beeinflusst wird, um justierinsensitiv in den optischen Eingang des Wellenleiters eingekoppelt zu werden.

In den **Fig. 6a-6d** sind neben einer Basiskonfiguration zur Reduzierung der Justageempfindlichkeit beim Einkoppeln eines vom Chip 2 kommenden optischen Signals Sₒ in das Kontaktierungsmodul 1 drei Varianten aufgeführt, bei denen die Eingänge der Wellenleiter, als optische Eingänge E_{oK} am Kontaktierungsmodul 1, speziell gestaltet sind, um die eingekoppelte Intensität des Signals zu erhöhen.
- Variante a), in **Fig. 6a****,** zeigt eine Basiskonfiguration ohne zusätzliche Optimierung, wie sie bereits anhand eines vorher beschriebenen Ausführungsbeispiels erläutert wurde. Das optische Signal Sₒ wird von einem optischen Ausgang A_{oC} des Chips 2, in dem ein Koppelelement, z. B. ein Grating-Koppler, angeordnet ist, unter einem Winkel, d. h. divergierend, abgestrahlt, trifft auf den Spiegel 1.2.1.2 und wird von dem Eingang des Wellenleiters 1.2.1.1 mit einer geringen Effizienz erfasst, da der Wellenleiterquerschnitt nur einen Bruchteil des ankommenden Strahlquerschnitts, der den Eingang des Wellenleiters in jeder Justierlage überstrahlt, abdeckt.
- Variante b), in **Fig. 6b****,** zeigt einen Taper 5.1, der am Eingang des Wellenleiters einen auf den Wellenleiterquerschnitt angepassten Querschnitt aufweist und in jeder Justierlage die gesamte Strahlungsintensität des optischen Signals Sₒ vollständig in den Wellenleiter lenkt, wenn der Strahlquerschnitt des in den Taper 5.1 einfallenden optischen Signals Sₒ entsprechend kleiner als die Eintrittsöffnung 5.1.1 des Tapers 5.1 ist.
- Variante c), in **Fig. 6c****,** verwendet anstatt das Tapers 5.1 mehrere, davon sind zwei dargestellt, in einem Minimalabstand zueinander angeordnete Wellenleiter (Wellenleitergruppe), die z. B. mittels laserdirektgeschriebenen Verzweigungen gekoppelt werden und so ebenfalls einen größeren Anteil der Signalintensität aufnehmen. Die mehreren Wellenleiter werden alle in jeder Justierlage vollständig überstrahlt.
- Variante d), in Fig. 6d, verwendet einen Hohlspiegel als Spiegel 1.2.1.2, zur Fokussierung des einfallenden optischen Signals Sₒ in den Wellenleiter, und einen Taper 5.1, wie bei der Variante b) erläutert, um das Signal trotz einer Fokuslagentoleranz in jeder der Justierlagen vollständig in den Wellenleiter einzukoppeln.

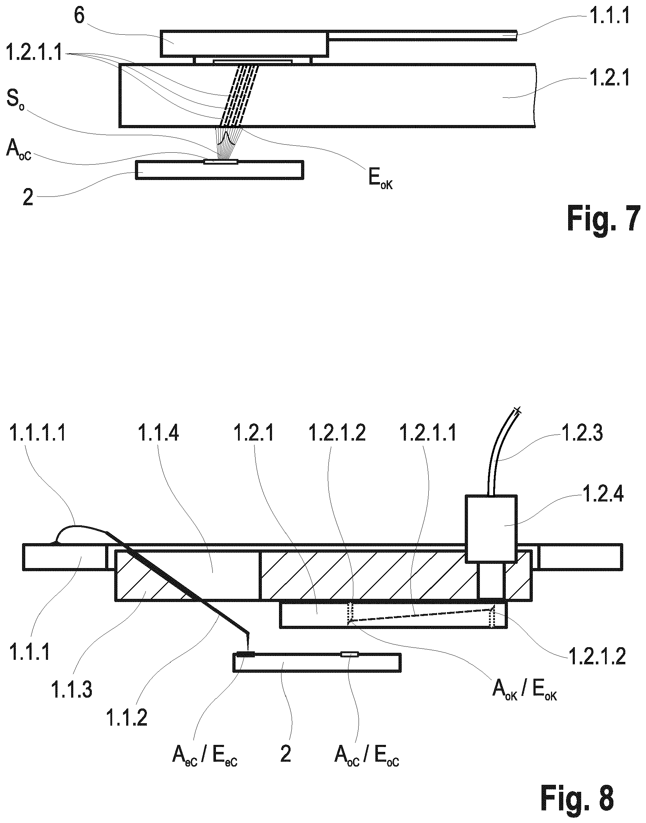

Die Varianten b)-d) sind auch miteinander kombinierbar. In **Fig. 7** ist ein nicht beanspruchtes Ausführungsbeispiel gezeigt, in dem ein optisches Signal Sₒ in jeder der Justierlagen in eine gleiche Anzahl von Wellenleitern eingekoppelt wird, die entweder alle auf eine Fotodiode 6 oder ein Fotodiodenarray führen oder (in den Zeichnungen nicht dargestellt) über Verzweigungen (Y-Junctions) in einen Wellenleiter zusammengeführt werden.

An allen optischen Grenzflächen im Strahlengang können auf die Wellenlänge und auf die Anwendung optimierte Antireflexionsschichten eingesetzt werden, um die Transmission zu erhöhen und Rückreflexionen zu minimieren. Vorzugsweise kommen mechanisch und chemisch stabile AR-Schichten z.B. unter Verwendung von SiO₂ zum Einsatz. Dies schützt den Optikblock, so dass eine für das Elektronikmodul typische Reinigung während des Messens nicht zu einer Beschädigung des Optikmoduls und damit des Optikblockes führt.

Die in den **Fig. 3a****-b** dargestellte seitliche Einkopplung der von der Testapparatur 4 kommenden optischen Signale Sₒ, über Glasfasern 1.2.3, die in dem mit V-Nuten gestalteten Faserhalter 1.2.2 zueinander und zu den im Optikblock 1.2.1 vorhandenen Wellenleitern ausgerichtet sind, bringt Limitierungen mit sich. So kann keine elektrische Kontaktierung auf der Seite des Chips 2 erfolgen, auf dem die Wellenleiter seitlich nach außen zu den Glasfasern 1.2.3 geführt werden.

Das in **Fig. 4** dargestellte Ausführungsbeispiel bietet nur eine bedingte Lösung dafür an. Eine wirkliche Alternative ist die Einkopplung der optischen Signale Sₒ in den Optikblock 1.2.1 von oben, anstatt von der Seite. Dazu wird entsprechend **Fig. 8** im Optikblock 1.2.1 ein zweiter Spiegel 1.2.1.2 implementiert und das optische Signal Sₒ von oben mittels Faser- oder Multi-Faserstecker 1.2.4 eingekoppelt. Der Faser- oder Multi-Faserstecker 1.2.4 kann entweder direkt auf den Optikblock 1.2.1 montiert werden (nicht abgebildet) oder auf der Trägerplatte 1.1.3 des Elektronikmoduls 1.1.

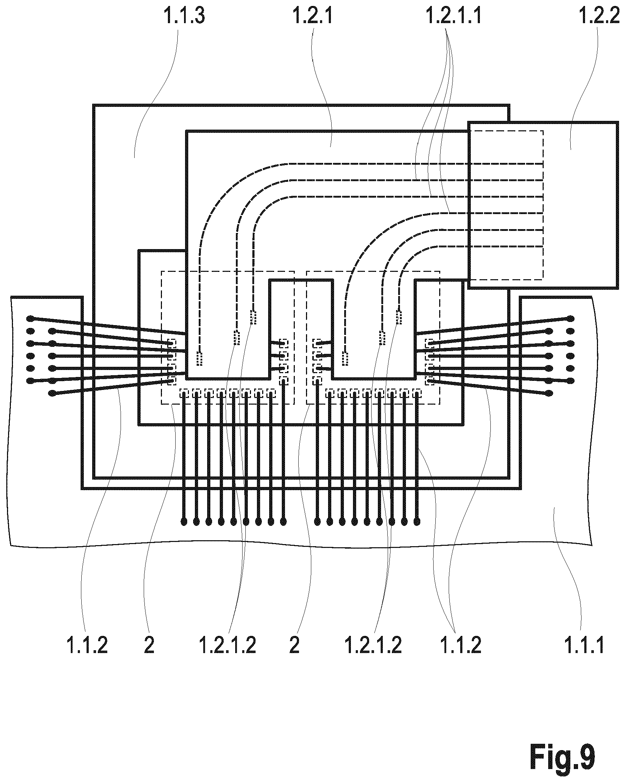

Das in **Fig. 3** dargestellte Ausführungsbeispiel zur Kontaktierung eines Chips 2 kann zu einer parallelen Kontaktierung mehrerer Chips 2, wie in **Fig. 9** dargestellt, erweitert werden. Dies erhöht den Durchsatz und verkürzt die Messzeit. Entscheidend dabei ist die monolithische Integration aller optischen Schnittstellen in einen Optikblock 1.2.1, um die durch das gewählte Fertigungsverfahren gegebenen hohen Positionsgenauigkeiten der optischen Schnittstellen untereinander zu erreichen. In der Abbildung ist die parallele Messung von zwei Chips 2 dargestellt, die Konfiguration ist auf die parallele Messung von noch mehr Chips 2 erweiterbar.

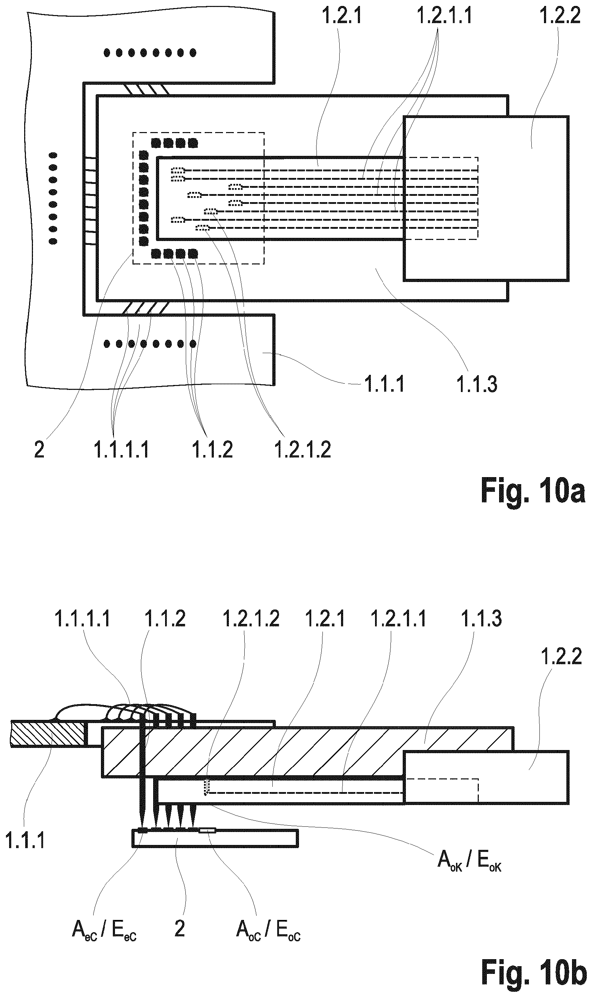

In Abwandlung von dem Ausführungsbeispiel, gezeigt in **Fig. 3a****-b,** bei dem als Kontaktnadeln 1.1.2 für die elektrische Kontaktierung Cantilever-Nadeln verwendet werden, werden in einem weiteren Ausführungsbeispiel, dargestellt in den **Fig. 10a und 10b****,** Vertikal-Nadeln verwendet. Der Optikblock 1.2.1 ist an der Unterseite der Trägerplatte 1.1.3 des Elektronikmoduls 1.1 montiert. Die Anzahl und Konfiguration der Vertical-Nadeln und Spiegel 1.2.1.2 ist nur exemplarisch dargestellt und kann auf verschiedene Designs eines Kontaktierungsmoduls 1 angepasst werden.

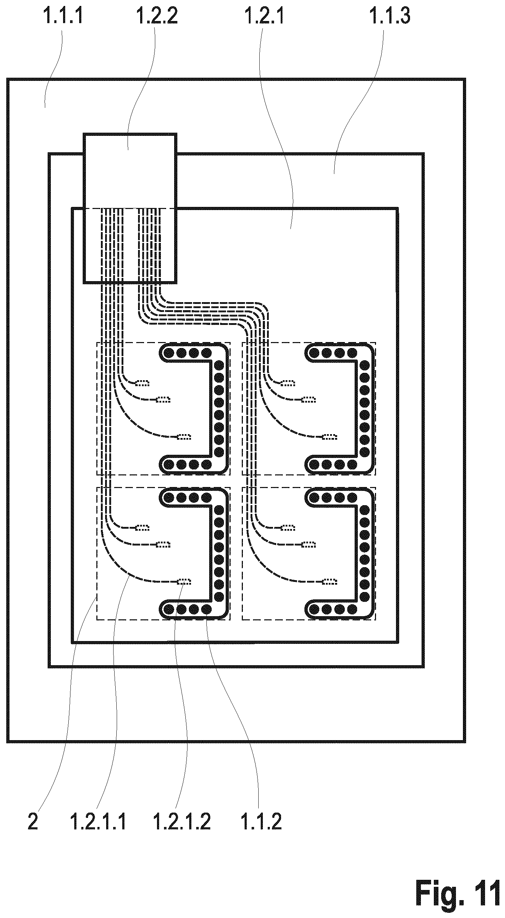

Eine schematische Darstellung eines Kontaktierungsmoduls 1 zur Messung von zwei mal zwei Chips 2, parallel unter Verwendung eines Elektronikmoduls 1.1 mit Vertical-Nadeln ist in Fig. 11 gezeigt. Der Aufbau und die Montage sind analog dem Ausführungsbeispiel nach **Fig. 10a und 10b****,** nur dass der Optikblock 1.2.1 mehrere Öffnungen zur Durchführung der Vertical-Nadeln enthält und das Routing der Wellenleiter entsprechend angepasst ist. Das Ausführungsbeispiel ist auf die parallele Messung von mehr als zwei mal zwei Chips 2 erweiterbar.

### Bezugszeichenliste

- 1: Kontaktierungsmodul
- 1.1: Elektronikmodul
- 1.1.1: Leiterplatte
- 1.1.1.1: elektrische Signalleitung
- 1.1.2: Kontaktnadeln
- 1.1.3: Trägerplatte
- 1.1.4: Keramikträger
- 1.2: Optikmodul
- 1.2.1: Optikblock
- 1.2.1.1: optische Signalleitungen (insbesondere Wellenleiter)
- 1.2.1.2: Spiegel
- 1.2.2: Faserhalter
- 1.2.3: Glasfaser
- 1.2.4: Faserstecker

- 2: (optoelektronischer) Chip
- 2.1: Kontaktplättchen
- 3: Waferplattform
- 4: Testapparatur

- 5.1: Taper
- 5.1.1: Eintrittsöffnung des Tapers 5.1
- 5.2: refraktives optisches Element
- 5.3: diffraktives optisches Element
- 5.4: Filter
- 6: Fotodiode
- 6.1: lichtempfindliche Fläche

- Sₑ: elektrisches Signal
- Sₒ: optisches Signal
- E_{oK}: optische Eingänge am Kontaktierungsmodul 1
- A_{oK}: optische Ausgänge am Kontaktierungsmodul 1
- E_{oC}: optische Eingänge des optoelektronischen Chips 2
- A_{oC}: optische Ausgänge des optoelektronischen Chips 2
- E_{eK}: elektrische Eingänge am Kontaktierungsmodul 1
- A_{eK}: elektrische Ausgänge am Kontaktierungsmodul 1
- E_{eC}: elektrische Eingänge des optoelektronischen Chips 2
- A_{eC}: elektrische Ausgänge des optoelektronischen Chips 2

## Patentansprüche

1. Kontaktierungsmodul (1) zur zeitlich aufeinanderfolgenden Kontaktierung optoelektronischer Chips (2) zwecks Übertragung von elektrischen und optischen Signalen (Sₑ, Sₒ) zwischen jeweils wenigstens einem der optoelektronischen Chips (2) und dem Kontaktierungsmodul (1), wobei die zeitlich aufeinanderfolgend kontaktierten optoelektronischen Chips (2) und das Kontaktierungsmodul (1) toleranzbedingt in voneinander abweichenden Justierlagen zueinander angeordnet sind,
mit im Kontaktierungsmodul (1) angeordneten elektrischen und optischen Signalleitungen (1.1.1.1, 1.2.1.1), die jeweils einen elektrischen oder optischen Ein- oder Ausgang aufweisen, die als elektrische oder optische Ein- oder Ausgänge (E_{eK}, E_{oK}, A_{eK}, A_{oK}) am Kontaktierungsmodul (1) jeweils einem elektrischen oder optischen Ein- oder Ausgang (E_{eC}, E_{oC}, A_{eC}, A_{oC}) des wenigstens einen optoelektronischen Chips (2) zugeordnet sind,
wobei die elektrischen Ein- und Ausgänge (E_{eK}, A_{eK}) am Kontaktierungsmodul (1) jeweils durch Kontaktnadeln (1.1.2) gebildet sind, die zur Übertragung der elektrischen Signale (Sₑ) jeweils mit einem der elektrischen Ein- bzw. Ausgänge (E_{eC}, A_{eC}) des wenigstens einen optoelektronischen Chips (2), die jeweils durch ein elektrisches Kontaktplättchen (2.1) gebildet sind, in jeder der Justierlagen mechanisch in Kontakt stehen, und
die optischen Ein- und Ausgänge (E_{oK}, A_{oK}) am Kontaktierungsmodul (1) mit den optischen Ein- und Ausgängen (E_{oC}, A_{oC}) des wenigstens einen optoelektronischen Chips (2) jeweils paarweise einen optischen Freistrahlbereich zur Übertragung der optischen Signale (Sₒ) begrenzen,
**dadurch gekennzeichnet,**
**dass** die von dem Kontaktierungsmodul (1) zu dem wenigstens einen optoelektronischen Chip (2) übertragenen optischen Signale (Sₒ) aufgrund der Länge des jeweiligen gebildeten Freistrahlbereiches von wenigen 10 µm bis einigen 100 µm und einer wenigstens leicht divergenten Abstrahlung des optischen Signals (Sₒ) jeweils eine größere Fläche eines der optischen Eingänge (E_{oC}) an dem wenigstens einen Chip (2) ausleuchten, als die Öffnung des jeweiligen optischen Eingangs (E_{oC}) an dem wenigstens einen Chips (2) groß ist, so dass die optischen Eingänge (E_{oC}) des wenigstens einen optoelektronischen Chips (2) in jeder der Justierlagen überstrahlt werden, und
**dass** das Kontaktierungsmodul (1) ein Elektronikmodul (1.1) mit den Kontaktnadeln (1.1.2) und einer Leiterplatte (1.1.1), in dem die elektrischen Signalleitungen (1.1.1.1) geführt sind, und ein Optikmodul (1.2) mit einem Optikblock (1.2.1) enthält, in dem die optischen und/oder elektrischen Signalleitungen (1.2.1.1, 1.1.1.1) geführt sind, die zu den optischen Ein- und Ausgängen (E_{oK}, A_{oK}) am Kontaktierungsmodul (1) führen, wobei die Leiterplatte (1.1.1) und der Optikblock (1.2.1) zueinander justiert fest angeordnet sind, und
**dass** die optischen Signalleitungen (1.2.1.1) im Optikblock (1.2.1) integrierte Wellenleiter sind, wobei die Ein- oder Ausgänge der Wellenleiter, die die optischen Ein- oder Ausgänge (E_{oK}, A_{oK}) am Kontaktierungsmodul (1) bilden, im Inneren des Optikblockes (1.2.1) liegen und jedem der Ein- oder Ausgänge (E_{oK}, A_{oK}) ein integrierter Spiegel (1.2.1.2) vorgeordnet ist, der die vom Wellenleiter kommenden optischen Signale (Sₒ) in eine zur Einkopplung in den wenigstens einen Chip (2) benötigte Richtung umlenkt.

2. Kontaktierungsmodul (1) nach Anspruch 1, **dadurch gekennzeichnet,**
**dass** die Leiterplatte (1.1.1) und der Optikblock (1.2.1) aus verschiedenem Material bestehen und die elektrischen und optischen Signalleitungen (1.1.1.1, 1.2.1.1) voneinander unabhängig durch verschiedene Technologien hergestellt wurden.

3. Kontaktierungsmodul (1) nach Anspruch 1, **dadurch gekennzeichnet,**
**dass** die Intensitätsverteilung im Strahlquerschnitt des optischen Signals (Sₒ) einer Gaußverteilung entspricht.

4. Kontaktierungsmodul (1) nach Anspruch 1, **dadurch gekennzeichnet,**
**dass** die Intensitätsverteilung im Strahlquerschnitt des optischen Signals (Sₒ) einer TOP-Hat-Verteilung entspricht.

5. Kontaktierungsmodul (1) nach Anspruch 1, **dadurch gekennzeichnet,**
**dass** der Optikblock (1.2.1) in seiner Dimension und Geometrie, einschließlich Durchbrüchen bzw. Öffnungen, so ausgeführt ist, dass alle am Elektronikmodul (1.1) vorhandenen Kontaktnadeln (1.1.2) an dem Optikblock (1.2.1) vorbei, um ihn herum und / oder gegebenenfalls durch in ihm ausgebildete Öffnungen hindurch mit dem Chip (2) in Kontakt stehen.

6. Kontaktierungsmodul (1) nach Anspruch 1, **dadurch gekennzeichnet,**
**dass** die Wellenleiter jeweils in einen Taper (5.1) münden, der am Eingang des Wellenleiters einen auf einen Wellenleiterquerschnitt angepassten Querschnitt aufweist und die gesamte Strahlungsintensität des optischen Signals (Sₒ) in jeder der Justierlagen vollständig in den Wellenleiter lenkt, wobei der Strahlquerschnitt des in den Taper (5.1) einfallenden optischen Signals (Sₒ) kleiner als eine Eintrittsöffnung (5.1.1) des Tapers (5.1) ist.

7. Kontaktierungsmodul (1) nach Anspruch 6, **dadurch gekennzeichnet,**
**dass** der Spiegel (1.2.1.2) als ein Hohlspiegel ausgeführt ist.

8. Kontaktierungsmodul (1) nach Anspruch 7, **dadurch gekennzeichnet,**
**dass** die Wellenleiter jeweils in eine vorgeordnete Wellenleitergruppe münden, deren Enden gemeinsam einen der optischen Eingänge (E_{oK}) bilden, der in jeder Justierlage vollständig überstrahlt wird, sodass ein größerer Anteil der Signalintensität als nur in einen Wellenleiter eingekoppelt wird.

## Claims

1. A contacting module (1) for the successive contacting of optoelectronic chips (2) for the purpose of transmitting electrical and optical signals (Sₑ, Sₒ) between, in each case, at least one of the optoelectronic chips (2) and the contacting module (1), wherein the successively contacted optoelectronic chips (2) and the contacting module (1) are arranged in different adjustment positions relative to one another due to tolerances,
with electrical and optical signal lines (1.1.1.1, 1.2.1.1) arranged in the contacting module (1), each having an electrical or optical input or output, which as electrical or optical inputs or outputs (E_{eK}, E_{oK}, A_{eK}, A_{oK}) on the contacting module (1) are each assigned to an electrical or optical input or output (E_{eC}, E_{oC}, A_{eC}, A_{oC}) of the at least one optoelectronic chip (2),
wherein the electrical inputs and outputs (E_{eK}, A_{eK)} on the contacting module (1) are each formed by contact pins (1.1.2) which, for transmitting the electrical signals (Sₑ), are each in mechanical contact, in each of the adjustment positions, with one of the electrical inputs or outputs (E_{eC}, A_{eC}) of the at least one optoelectronic chip (2), which are each formed by an electrical contact plate (2.1), and
the optical inputs and outputs (E_{oK}, A_{oK}) on the contacting module (1) and the optical inputs and outputs (E_{oC}, A_{oC}) of the at least one optoelectronic chip (2) together delimit, in respective pairs, an optical free beam region for the transmission of the optical signals (Sₒ),
**characterized in that**
the optical signals (Sₒ) transmitted from the contacting module (1) to the at least one optoelectronic chip (2), due to the length of the respective free beam region formed-ranging from a few tens of µm to several hundreds of µm-and at least slightly divergent radiation of the optical signal (Sₒ), illuminate an area of one of the optical inputs (E_{oC}) on the at least one chip (2) that is larger than the aperture of the respective optical input (E_{oC}) on the at least one chip (2), such that the optical inputs (E_{oC}) of the at least one optoelectronic chip (2) are irradiated in each of the adjustment positions, and
the contacting module (1) includes an electronic module (1.1) with the contact pins (1.1.2) and a printed circuit board (1.1.1), in which the electrical signal lines (1.1.1.1) are guided, and an optical module (1.2) with an optical block (1.2.1), in which the optical and/or electrical signal lines (1.2.1.1, 1.1.1.1) are guided, which lead to the optical inputs and outputs (E_{oK}, A_{oK}) on the contacting module (1), with the printed circuit board (1.1.1) and the optical block (1.2.1) being fixedly arranged in a mutually adjusted manner, and
that the optical signal lines (1.2.1.1) are waveguides integrated in the optical block (1.2.1), wherein the inputs or outputs of the waveguides, which form the optical inputs or outputs (E_{oK}, A_{oK}) on the contacting module (1), are located inside the optical block (1.2.1) and each of the inputs or outputs (E_{oK}, A_{oK}) is preceded by an integrated mirror (1.2.1.2) which deflects the optical signals (Sₒ) coming from the waveguide in a direction required for coupling into the at least one chip (2).

2. The contacting module (1) according to claim 1, **characterized in that**
the printed circuit board (1.1.1) and the optical block (1.2.1) are made of different materials and the electrical and optical signal lines (1.1.1.1, 1.2.1.1) were manufactured independently of each other by different technologies.

3. The contacting module (1) according to claim 1, **characterized in that**
the intensity distribution in the beam cross-section of the optical signal (Sₒ) corresponds to a Gaussian distribution.

4. The contacting module (1) according to claim 1, **characterized in that** the intensity distribution in the beam cross-section of the optical signal (Sₒ) corresponds to a top-hat distribution.

5. The contacting module (1) according to claim 1, **characterized in that** the dimension and geometry of the optical block (1.2.1), including breakthroughs and/or openings, are configured in such a way that all contact pins (1.1.2) present on the electronic module (1.1) are in contact with the chip (2) past the optical block (1.2.1), around it and/or if necessary through openings formed therein.

6. The contacting module (1) according to claim 1, **characterized in that** the waveguides each end in a taper (5.1), which has a cross-section adapted to a waveguide cross-section at the entrance of the waveguide and directs the entire radiation intensity of the optical signal (Sₒ) completely into the waveguide in each of the adjustment positions, the beam cross-section of the optical signal (Sₒ) incident into the taper (5.1) being smaller than an entrance opening (5.1.1) of the taper (5.1).

7. The contacting module (1) according to claim 6, **characterized in that** the mirror (1.2.1.2) is designed as a concave mirror.

8. The contacting module (1) according to claim 7, **characterized in that**
the waveguides each end in an upstream waveguide group, whose ends together form one of the optical inputs (E_{oK}), which is completely irradiated in each adjustment position, so that a larger proportion of the signal intensity is coupled in than into just one waveguide.

## Revendications

1. Module de contact (1) destiné au contact successif dans le temps de puces optoélectroniques (2) en vue de la transmission de signaux électriques et optiques (Sₑ, Sₒ) entre, à chaque fois, au moins l'une des puces optoélectroniques (2) et le module de contact (1), les puces optoélectroniques (2) mises en contact successivement dans le temps et le module de contact (1) étant disposés l'un par rapport à l'autre dans des positions d'ajustement différentes en raison des tolérances,
avec des lignes de signalisation électriques et optiques (1.1.1.1, 1.2.1.1) disposées dans le module de contact (1), qui comportent chacune une entrée ou une sortie électrique ou optique respectivement associées, en tant qu'entrées ou sorties électriques ou optiques (E_{eK}, E_{oK}, A_{eK}, A_{oK}) sur le module de connexion (1), à une entrée ou une sortie électrique ou optique (E_{eC}, E_{oC}, A_{eC}, A_{oC}) de la au moins une puce optoélectronique (2),
les entrées et sorties électriques (E_{eK}, A_{eK}) du module de contact (1) étant formées respectivement par des broches de contact (1.1.2) qui, pour la transmission des signaux électriques (Sₑ), sont chacune en contact mécanique, dans chacune des positions d'ajustement, avec l'une des entrées ou sorties électriques (E_{eC}, A_{eC}) de la au moins une puce optoélectronique (2), qui sont chacune constituées d'une plaquette de contact électrique (2.1), et
les entrées et sorties optiques (E_{oK}, A_{oK}) du module de contact (1) délimitent, par paires, avec les entrées et sorties optiques (E_{oC}, A_{oC}) de la au moins une puce optoélectronique (2), une zone de faisceau optique libre destinée à la transmission des signaux optiques (Sₒ),
**caractérisé**
**en ce que** les signaux optiques (Sₒ) transmis par le module de contact (1) à la au moins une puce optoélectronique (2) éclairent, en raison de la longueur de la zone de faisceau libre formée, comprise entre quelques dizaines de µm et quelques centaines de µm, et d'un rayonnement au moins légèrement divergent du signal optique (Sₒ), une surface plus grande de l'une des entrées optiques (E_{oC}) sur la au moins une puce (2) que l'ouverture de l'entrée optique correspondante (E_{oC}) sur la au moins une puce (2), de sorte que les entrées optiques (E_{oC}) de la au moins une puce optoélectronique (2) sont suréclairées dans chacune des positions d'ajustement, et
**en ce que** le module de contact (1) comprend un module électronique (1.1) comportant les broches de contact (1.1.2) et une carte de circuit imprimé (1.1.1) dans laquelle sont acheminées les lignes de signalisation électriques (1.1.1.1), ainsi qu'un module optique (1.2) comprenant un bloc optique (1.2.1), dans lequel sont acheminées les lignes de signalisation optiques et/ou électriques (1.2.1.1, 1.1.1.1), qui mènent aux entrées et sorties optiques (E_{oK}, A_{oK}) du module de contact (1), la carte de circuit imprimé (1.1.1) et le bloc optique (1.2.1) étant disposés de manière fixe et alignés l'un par rapport à l'autre, et
**en ce que** les lignes de signalisation optiques (1.2.1.1) sont des guides d'ondes intégrés dans le bloc optique (1.2.1), les entrées ou sorties des guides d'ondes, qui forment les entrées ou sorties optiques (E_{oK}, A_{oK}) sur le module de contact (1), se trouvant à l'intérieur du bloc optique (1.2.1) et chacune des entrées ou sorties (E_{oK}, A_{oK}) étant précédée d'un miroir intégré (1.2.1.2) qui redirige les signaux optiques (Sₒ) provenant du guide d'ondes dans une direction nécessaire au couplage dans la au moins une puce (2).

2. Module de contact (1) selon la revendication 1, **caractérisé**
**en ce que** le circuit imprimé (1.1.1) et le bloc optique (1.2.1) sont constitués de matériaux différents et que les lignes de signalisation électriques et optiques (1.1.1.1, 1.2.1.1) ont été fabriquées indépendamment les unes des autres à l'aide de technologies différentes.

3. Module de contact (1) selon la revendication 1, **caractérisé**
**en ce que** la répartition de l'intensité dans la section transversale du faisceau du signal optique (Sₒ) suit une loi de Gauss.

4. Module de contact (1) selon la revendication 1, **caractérisé en ce que** la répartition de l'intensité dans la section transversale du faisceau du signal optique (Sₒ) correspond à une distribution de type « TOP-Hat ».

5. Module de contact (1) selon la revendication 1, **caractérisé en ce que** le bloc optique (1.2.1) est conçu, en termes de dimensions et de géométrie, y compris des brèches ou des ouvertures, est conçu de telle sorte que toutes les broches de contact (1.1.2) présentes sur le module électronique (1.1) soient en contact avec la puce (2) en passant à côté du bloc optique (1.2.1), en le contournant et/ou, le cas échéant, en traversant des ouvertures formées dans celui-ci.

6. Module de contact (1) selon la revendication 1, **caractérisé en ce que** les guides d'ondes débouchent chacun dans un cône (5.1) qui présente, à l'entrée du guide d'ondes, une section transversale adaptée à celle du guide d'ondes et par lequel l'intensité du rayonnement du signal optique (Sₒ) est entièrement déviée dans le guide d'ondes dans chacune des positions d'ajustement, la section transversale du faisceau du signal optique (Sₒ) incident dans le cône (5.1) étant inférieure à celle d'une ouverture d'entrée (5.1.1) du cône (5.1).

7. Module de contact (1) selon la revendication 6, **caractérisé en ce que** le miroir (1.2.1.2) est réalisé sous la forme d'un miroir concave.

8. Module de contact (1) selon la revendication 7, **caractérisé**
**en ce que** les guides d'ondes débouchent chacun dans un groupe de guides d'ondes situé en amont, dont les extrémités forment ensemble l'une des entrées optiques (E_{oK}), qui est entièrement suréclairée dans chaque position d'ajustement, de sorte qu'une plus grande partie de l'intensité de signal est injectée que dans un seul guide d'ondes.
